# EUROPEAN PATENT APPLICATION

(11) **EP 1 292 014 A2**
(43) Date of publication of application: **12.03.2003**
(21) Application number: 02003832.9
(22) Date of filing: 20.02.2002
(51) Int. Cl.: H03B 5/18

(54) **Dielectric resonator oscillator and transmitting/receiving module utilizing it**

(30) Priority: 10.09.2001 JP 2001273050
(71) Applicant: Hitachi, Ltd., Chiyoda-ku, Tokyo 101-8010 (JP)
(72) Inventor: Kurita, Naoyuki, c/o Hitachi, Ltd., Chiyoda-ku, Tokyo 100-8220 (JP); Nagasaku, Toshiyuki, c/o Hitachi, Ltd., Chiyoda-ku, Tokyo 100-8220 (JP); Kondoh, Hiroshi, c/o Hitachi, Ltd., Chiyoda-ku, Tokyo 100-8220 (JP)
(74) Representative: Strehl Schübel-Hopf & Partner

(57) **Abstract**

A dielectric resonator oscillator with little manufacturing variations, low cost, and low phase noise characteristic, in which one terminal of an active element of a monolithic integrated circuit 24 is connected to a coupled line 3 formed on a dielectric substrate 21 via a wire 23, a dielectric resonator 1 having the shape of a column whose bottom face has a polygon shape having five or more sides is formed on the dielectric substrate 21, and the dielectric resonator 1 is electromagnetically coupled to the coupled line 3. When a transmitting and receiving module for use in a radar system is formed by using the dielectric resonator oscillator, the system can be formed at low cost and the maximum distance to an object which can be detected can be increased.

## Description

### BACKGROUND OF THE INVENTION

### Field of the invention

The present invention relates to a dielectric resonator oscillator and a transmitting/receiving module utilizing the same. More particularly, the invention relates to a transmitting and receiving module using, as a signal source, a dielectric resonator oscillator used in a microwave and millimeter wave band and constructed by a dielectric resonator made of a high permittivity material and a monolithic integrated circuit.

### Description of the Related Arts

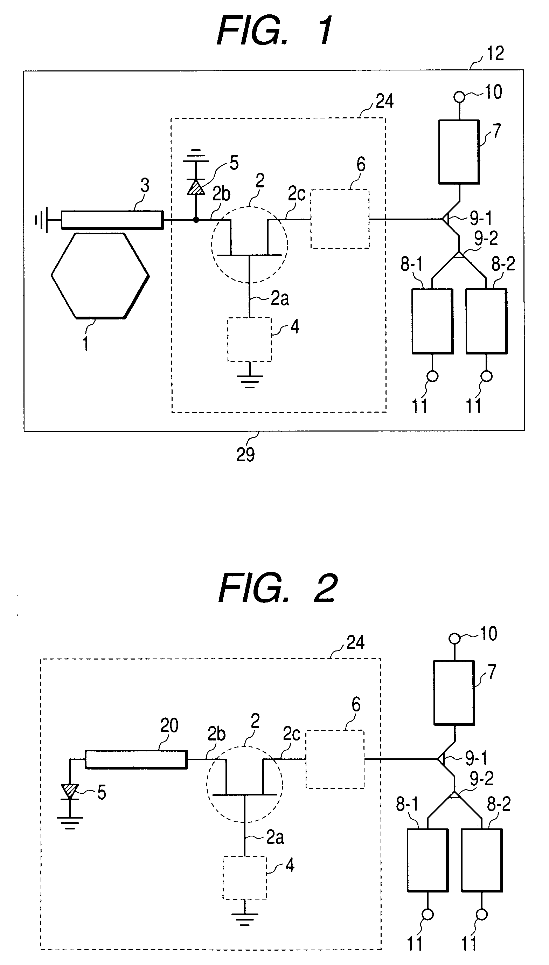

A transmitting and receiving module of this kind is used for an automotive radar apparatus and required to be small and to be realized at low cost for the use. Conventionally, as shown in FIG. 2, in a signal source of main components of the transmitting and receiving module, an oscillator circuit takes the form of a monolithic integrated circuit 24 on a semiconductor substrate. An output of the oscillator circuit is supplied via power dividers 9-1 and 9-2, a transmitting antenna connecting terminal 10, and a receiving antenna connecting terminal 11 to transmitting and receiving antennas (not shown).

In the oscillator circuit taking the form of the monolithic integrated circuit 24, a reactance element 4 is connected to, for example, a gate terminal 2a of a field effect transistor 2 and parameters of circuit devices are determined so that negative resistance appears in a desired frequency bandwidth. A resonator taking the form of a micro strip line 20 is connected to a source terminal 2b, and an oscillation frequency is unconditionally determined according to the length of the micro strip line 20. An oscillation signal is amplified by a buffer amplifier 6 connected to a drain terminal 2c and an amplified signal is generated as an output signal. For example, as disclosed in Technical Report of IEICE of Japan ED99-276, a generated high frequency signal is divided by the first power divider 9-1 into two. One of them is transmitted to a transmitting antenna via a monolithic integrated circuit 7 in which a power amplifier is formed, and the other signal is further divided into two by the second power divider 9-2 and the resultant signals are input to local signal terminals of monolithic integrated circuits 8 of two receivers. The high frequency signal sent from the transmitting antenna is subjected to Doppler shift in association with reflection from an object existing in front of the antenna and the resultant signal is received by the receiving antenna. The reception signal is mixed with a local signal in a receiver, thereby generating an intermediate frequency (IF) signal. By a series of circuit operations, the distance up to the object positioned in front of the transmitting and receiving module and relative speed can be detected. By providing two receiving antennas, an angle in a one-dimensional direction of the object can be detected from a phase difference between signals received by the antennas.

In the conventional technique, the resonator included in the oscillator circuit takes the form of the micro strip line 20.

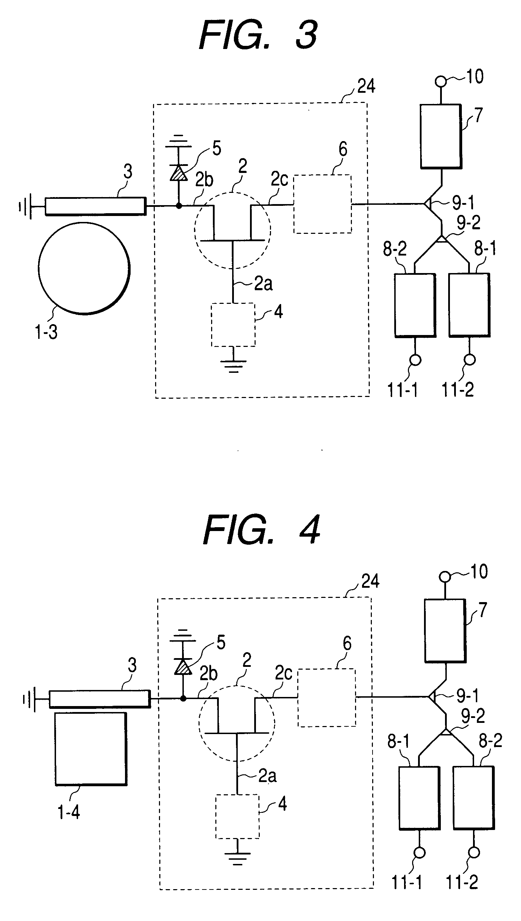

Other conventional techniques are also known in which, as shown in FIG. 3, a cylindrical dielectric resonator 1-3 made of a high permittivity material such as ceramic is used as a resonator included in an oscillator circuit or, as shown in FIG. 4, a dielectric resonator 104 having a rectangular parallelepiped shape is used as an resonator. Substantially the same components in FIGS. 3 and 4 as those in FIG. 2 will be designated by the same reference numerals and their description will not be repeated.

In the oscillator which does not use a dielectric resonator as shown in FIG. 2, the Q factor of the resonator is low, so that phase noise in an oscillation signal is large. As a result, when the oscillator is used for the transmitting and receiving module, there are problems such that the performance of the transmitting and receiving module itself deteriorates, for example, the maximum distance in which the object can be detected becomes shorter. In the case of using the cylindrical dielectric resonator shown in FIG. 3, the phase noise is reduced and, accordingly, the performance of the transmitting and receiving module becomes better. However, there are problems such that the manufacturing cost at the time of mass production is high, and it is difficult to mass produce the modules while suppressing variations in the diameter of the bottom face.

The dielectric resonator of the rectangular parallelepiped shape shown in FIG. 4 can be manufactured more easily as compared with the case where the resonator is shaped in a cylindrical shape, and both variations in manufacture and manufacturing cost can be suppressed. However, the dielectric resonator shown in FIG. 4 has a characteristic such that the electromagnetic field tends to be concentrated on the four vertexes of the resonator and the Q factor is lower than that of the cylindrical resonator.

### SUMMARY OF THE INVENTION

It is therefore an object of the invention to realize a dielectric resonance oscillator achieving a lower manufacturing cost at the time of mass production and improved characteristics such as reduced phase noise required to a transmitting and receiving module, and a transmitting and receiving module using the same.

To achieve the object, according to the invention, a terminal of an active element on a monolithic integrated circuit on which an oscillator circuit is formed is connected to a coupled line formed on a dielectric substrate, and a dielectric resonator made of a high permittivity material and having a column shape whose bottom face is of a polygon shape having five or more sides is disposed on the dielectric substrate and is electromagnetically coupled to the coupled line. With the configuration, the oscillator circuit functions as a dielectric resonator oscillator as a main component of a transmitting and receiving module.

By employing the dielectric resonator oscillator using the dielectric resonator having a column shape whose base face has a polygon shape having five or more sides as a component of the transmitting and receiving module, the manufacturing cost can be suppressed as compared with the transmitting and receiving module using a conventional cylindrical dielectric resonator. Further, variations in dimension of the dielectric resonator are also reduced, so that variations in the oscillation frequency of the dielectric resonator oscillator included in a transmitting and receiving module at the time of mass production are reduced, and remarkably improved mass production yield can be achieved.

Phase noise in an oscillation signal of the transmitting and receiving module using the dielectric resonator having the above column shape is reduced as compared with a transmitting and receiving module using a dielectric resonator having a rectangular parallelepiped shape. In the case of using the transmitting and receiving module of the invention for a radar system, an effect such that the maximum distance to an object which can be detected by the transmitting and receiving module can be increased is produced.

### BRIEF DESCRITPON OF THE DRAWINGS

FIG. 1 is a circuit diagram showing the configuration of an example of a transmitting and receiving module according to the invention.

FIG. 2 is a circuit diagram showing the configuration of a transmitting and receiving module of a first conventional technique.

FIG. 3 is a circuit diagram showing the configuration of a transmitting and receiving module of a second conventional technique.

FIG. 4 is a circuit diagram showing the configuration of a transmitting and receiving module of a third conventional technique.

FIG. 5 is a plan view showing an example of a dielectric resonator oscillator according to the invention.

FIG. 6 is a plan view showing a first example of a transmitting and receiving module according to the invention.

FIG. 7 is a plan view showing another example of the dielectric resonator oscillator according to the invention.

FIG. 8 is a plan view showing a second example of the transmitting and receiving module according to the invention.

FIG. 9 is a plan view showing further another example of the dielectric resonator oscillator according to the invention.

FIGS. 10A and 10B are diagrams showing measurement data for explaining an effect on manufacturing yield of a dielectric resonator having a hexagonal prism shape.

### DESCRIPTION OF THE PREFERRED EMBODIMENTS

Embodiments of the invention will be described hereinbelow with reference to the drawings.

FIG. 1 is a configuration diagram showing an example of a transmitting and receiving module according to the invention. The transmitting and receiving module has: a monolithic integrated circuit 24 formed on a semiconductor substrate; a coupled line 3 provided outside of the semiconductor substrate and connected between the monolithic integrated circuit 24 and the ground; a dielectric resonator 1 disposed close to the coupled line 3 and made of a material having high permittivity such as ceramic; a monolithic integrated circuit 7 of a power amplifier formed on the semiconductor substrate and connected to an output of the monolithic integrated circuit 24 via power dividers 9-1 and 9-2; and monolithic integrated circuits 8-1 and 8-2 of two receivers.

The monolithic integrated circuits 24, 7, 8-1, and 8-2, dielectric resonator 1, and the like are formed on a mounting substrate 29. On the back face (not shown) of a mounting substrate 12, a transmitting antenna and a receiving antenna are formed and connected to the monolithic integrated circuits 7, 8-1, and 8-2 via terminals 10 and 11.

The monolithic integrated circuit 24, coupled line 3, and dielectric resonator 1 construct a dielectric resonator oscillator for generating a high frequency signal. The monolithic integrated circuit 24 includes a reactance element 4 connected between a gate terminal 2a of a field effect transistor 2 and the ground, a varactor 5 connected between a source terminal 2b and the ground, and a buffer amplifier 6 connected to the drain terminal 2c. The parameters of the circuit elements are determined so that negative resistance appears in a desired frequency bandwidth.

The dielectric resonator 1 is of a column body whose bottom face has a polygon shape having five or more sides (the diagram shows the case of a hexagon). At a desired resonance frequency unconditionally determined by the bottom area and the height of the dielectric resonator 1, by electromagnetically coupling the dielectric resonator 1 to the coupled line 3, the oscillating condition of the dielectric resonator 1 is satisfied and an oscillating operation is realized. An oscillation signal is amplified by the buffer amplifier 6 connected to the drain terminal 2c and the amplified signal is generated as an output signal. The output high frequency signal is divided by the first power divider 9-1 into two. One of the signals is transmitted via the monolithic integrated circuit 7 in which the power amplifier is constructed and the terminal 10 to the transmitting antenna. The other signal is further divided by the second power divider 9-2 into two, and the two signals are input to local signal terminals of the monolithic integrated circuits 8-1 and 8-2 of two receivers.

The high frequency signal sent from the transmitting antenna is subjected to Doppler shift in association with reflection from the object and the resultant is received by the receiving antenna. The reception signal is mixed with a local signal in the monolithic integrated circuits 8-1 and 8-2 of the receivers, thereby generating an intermediate frequency (IF) signal. By a series of circuit operations, relative speed and the distance up to the object positioned in front of the radar system constructed by the transmitting and receiving module and the transmitting and receiving antennas can be detected. By providing two receiving antennas, an angle in one dimensional direction of the object can be detected from a phase difference between signals received by the antennas.

In the embodiment, by using a column shape whose bottom face is hexagonal as the shape of the dielectric resonator 1, the process for controlling the geometry at low cost can be realized, and variations in the oscillation frequency at the time of mass production of the transmitting and receiving module can be reduced as compared with the case of using the conventional dielectric resonator of the cylindrical shape. To manufacture the dielectric resonator of the cylindrical shape, a polishing work has to be done in a process of shaping the side face as a curved surface. Consequently, variations in the diameter of the bottom face of the dielectric resonator and distortion in the shape of the bottom face occur more. In contrast, in the dielectric resonator having a column shape whose bottom face has a polygon shape, side faces are planes only. The shaping process is therefore simpler and the variations in the shape at the time of mass production can be also reduced as compared with the case of the cylindrical dielectric resonator. Since the manufacturing process becomes simpler, the manufacturing cost can be accordingly suppressed.

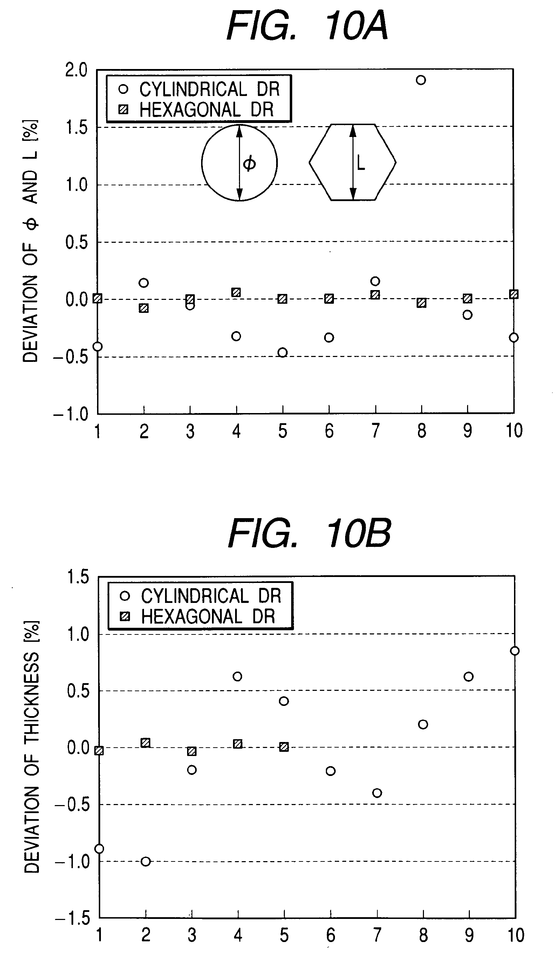

FIGS. 10A and 10B show data obtained by measuring deviations in the direction of the cross sections (diameters) L and φ and deviations in thickness (t) when 10 samples of cylindrical dielectric resonators and 10 samples of dielectric resonators of a hexagonal prism shape were manufactured by a simple manufacturing method. From FIGS. 10A and 10B, it is understood that the deviations L, φ, and t of the dielectric resonator of the hexagonal prism shape are smaller than those of the cylindrical dielectric resonator.

From the point that the side faces are only planes, the effect of the dielectric resonator of the hexagonal prism shape can be also obtained by a dielectric resonator of a rectangular parallelepiped shape. However, in the case of using the dielectric resonator of the rectangular parallelepiped shape for an oscillator in the transmitting and receiving module, concentration and leak of electric-magnetic field in the portion of the vertexes of the dielectric resonator conspicuously occur, and the Q factor of the resonator becomes lower than that in the cylindrical dielectric resonator. In association with this, phase noise of the oscillator becomes worse and it causes deterioration in the performance of the transmitting and receiving module. In contrast, in the case of the dielectric resonator having a column shape whose bottom face has five or more sides, the angle formed between two sides drawn from each vertex is an obtuse angle. Consequently, concentration and leak of the electric-magnetic field do not easily occur as compared with the dielectric resonator of the rectangular parallelepiped shape. Thus, deterioration in performance does not easily occur as compared with the transmitting and receiving module using the dielectric resonator of the rectangular parallelepiped shape, and the performance equivalent to that of the transmitting and receiving module using the cylindrical dielectric resonator can be maintained.

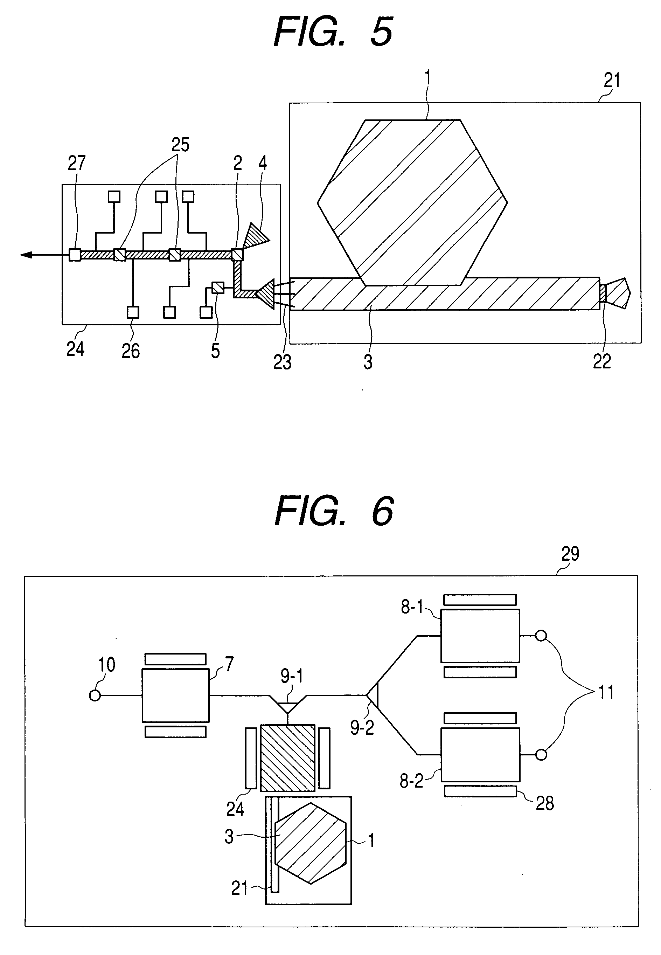

FIG. 5 is a plan view showing an example of a dielectric resonator oscillator as a component of a transmitting and receiving module according to the invention. The field effect transistor 2 for oscillation, reactance element 4, varactor 5, a field effect transistor 25 for amplifying the buffer, and a pad 26 for supplying bias are formed on the monolithic integrated circuit 24. A dielectric substrate 21 is disposed adjacent to the monolithic integrated circuit 24. On the dielectric substrate 21, the coupled line 3 for constructing the resonator is formed. The tip of one of ends of the coupled line 3 is electrically connected to a pad formed on the semiconductor substrate 24 via a bonding wire 23. The dielectric resonator 1 is mounted near or on the coupled line 3. At a desired resonance frequency unconditionally determined by the area of the bottom, height, and permittivity of the material, by electromagnetically coupling the dielectric resonator 1 and the coupled line 3, the oscillating condition is satisfied, and the oscillating operation of the oscillation circuit is realized. A terminator 22 is formed at the other end of the coupled line 3 to prevent that an electric-magnetic field having a frequency other than the resonance frequency causes unnecessary reflection and the operation of the circuit is made unstable.

FIG. 6 is a schematic diagram showing the configuration of a transmitting and receiving module using the dielectric resonator oscillator shown in FIG. 5. On the base plate (mounting substrate) 29, a low permittivity substrate 21 as a component of the dielectric resonator oscillator shown in FIG. 5 and the monolithic integrated circuit 24 as the oscillator circuit are disposed in the center portion and construct a transmitting and receiving circuit together with the monolithic integrated circuit 7 of the power amplifier and the monolithic integrated circuits 8-1 and 8-2 of the receivers. The connector 10 to the transmitting antenna is connected to the monolithic integrated circuit 7, and the connectors 11 to the receiving antenna are connected to the monolithic integrated circuits 8-1 and 8-2 and are electrically connected to antennas (not shown) formed on the opposite face of the base plate 29. A chip capacitor 28 for stabilizing the operation of a DC bias circuit is mounted near the monolithic integrated circuits 8-1 and 8-2 provided on the base plate 29. A DC voltage is applied to each of the monolithic integrated circuits 8-1 and 8-2 via the chip capacitor 28.

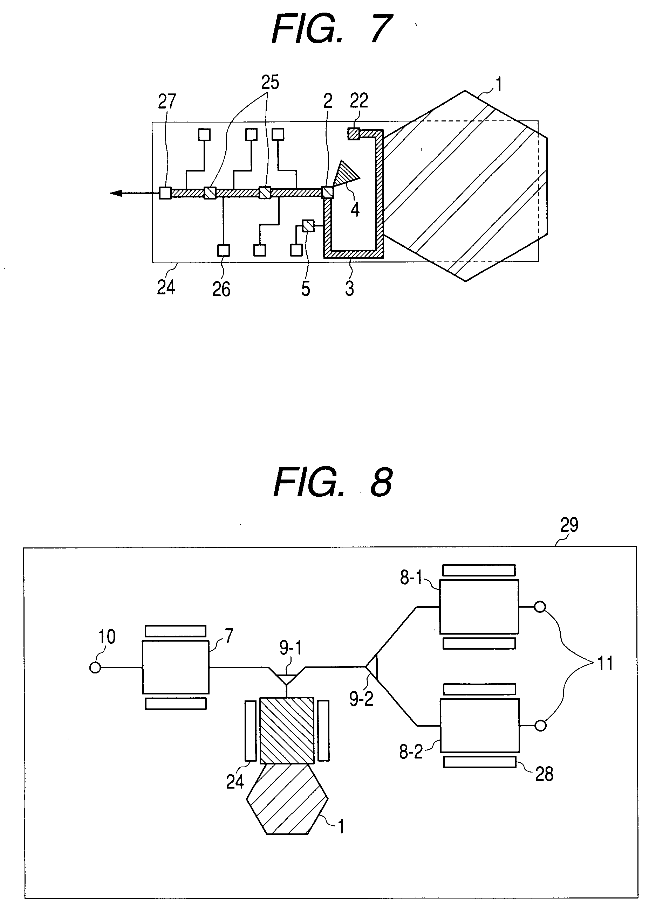

FIG. 7 is a plan view of another example of the dielectric resonator oscillator as a component of the transmitting and receiving module according to the invention. In the embodiment, as compared with the oscillator shown in FIG. 5, the dielectric substrate 21 is not used, but the dielectric resonator 1 is directly mounted on the semiconductor substrate on the monolithic circuit 24.

The field effect transistor 2 for oscillation, reactance element 4, varactor 5, field effect transistor 25 for amplifying the buffer, pad 26 for bias power supply, and coupled line 3 are formed on the monolithic integrated circuit 24. In the monolithic integrated circuit 24, a space for mounting the dielectric resonator is assured on the right side, and the dielectric resonator 1 having the shape of a column body whose bottom face is a pentagon is mounted. The coupled line 3 formed on the monolithic integrated circuit 24 is positioned near the dielectric resonator 1. By electromagnetically coupling the coupled line 3 to the dielectric resonator 1, the oscillating operation is performed.

FIG. 8 is a schematic diagram showing the configuration of a transmitting and receiving module including the dielectric resonator oscillator shown in FIG. 7. The configuration and the operation principle are the same as those of the transmitting and receiving module shown in FIG. 6 except that a low permittivity substrate for mounting thereon the dielectric resonator 1 having the column shape whose bottom face is a polygon (hexagon) is not used.

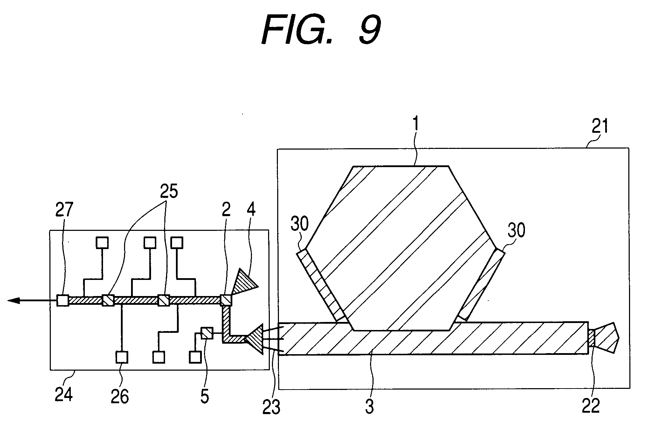

FIG. 9 is a plan view of another example of the dielectric resonator oscillator as a component of the transmitting and receiving module according to the invention. In the embodiment, to further suppress variations in the performance at the time of mass production of the transmitting and receiving module according to the invention, a structure 30 such as a guide or groove is provided in the dielectric substrate 21 on which the dielectric resonator 1 is disposed. Since the structure 30 may be formed by using a material equivalent to that of the dielectric substrate 21 on the dielectric substrate 21 so as not to exert an influence on the resonance characteristic of the resonator as much as possible, or the structure may be integrated with the dielectric substrate 21. In the case of using a cylindrical dielectric resonator, the structure 30 such as the guide or groove has to be formed in a circular arc shape. However, in the case of the dielectric resonator of a polygonal column, a linear shape may be used and it is consequently advantageous from the viewpoint of assuring the accuracy. By providing the structure such as a guide or groove, the dielectric resonator 1 having a column shape whose bottom face is hexagonal can be easily disposed close to the coupled line 3 with high precision. As a result, variations in the oscillation frequency of the dielectric resonator oscillator at the time of mass production can be suppressed. The oscillator shown in FIG. 9 relates to an example of the case where the dielectric resonator is mounted on the dielectric substrate disposed adjacent to the monolithic integrated circuit. Also in the case of disposing the dielectric resonator on the semiconductor substrate on which the monolithic integrated circuit is formed as shown in FIG. 7, by providing the structure such as a guide or groove in a portion in which the dielectric resonator is disposed on the semiconductor substrate in order to easily perform the process of attaching the dielectric resonator with high precision, the dielectric resonator can be easily disposed in a position adjacent to the coupled line with high precision.

Although the example of using the dielectric resonator having a column shape whose bottom face is hexagonal which is particularly easily manufactured has been described in the embodiment of the invention, the invention can be also applied to a column shape whose bottom face is of a polygon shape having five (pentagon) or more sides, in which the angle formed between two sides drawn from each vertex is an obtuse angle. Although the transmitting and receiving module used for an automotive radar system has been described, obviously, it can be used as a general small high frequency oscillator requested to have high manufacturing yield.

## Claims

1. A transmitting and receiving module for transmitting a microwave or millimeter wave band signal, receiving a signal subjected to Doppler shift and reflected by an object, comprising:
a first monolithic integrated circuit (24) including an oscillator; and
a second monolithic integrated circuit (8) including a receiver,
wherein a terminal of an active element (2) on said first monolithic integrated circuit (24) is grounded via a coupled line (3), and a dielectric resonator (1) made of a high permittivity material and having a column shape whose bottom face is of a polygon shape having five or more sides is electromagnetically coupled to said coupled line (3).

2. The transmitting and receiving module according to claim 1, wherein said dielectric resonator (1) is disposed on a semiconductor substrate (12, 29) as a component of said second monolithic integrated circuit (8).

3. The transmitting and receiving module according to claim 1, wherein said coupled line (3) and said dielectric resonator (1) are disposed on a mounting substrate (12, 29) on which said first monolithic integrated circuit (8) is mounted.

4. A dielectric resonator oscillator comprising:
an active element (2);
a coupled line (3) connected between one terminal of said active element and ground; and
a dielectric resonator (1) provided close to said coupled line,
wherein said dielectric resonator (1) is made of high permittivity material and has a column shape whose bottom face has a polygon shape having five or more sides.

5. The dielectric resonator oscillator according to claim 4, wherein said active element (2) is constructed as a monolithic integrated circuit (24) on a semiconductor substrate (12, 29), and said coupled line (3) and said dielectric resonator (1) are disposed on said semiconductor substrate (12, 29) or a dielectric mounting substrate (21) on which said monolithic integrated circuit (24) is mounted.

6. The invention of any preceding claim, wherein the shape of a bottom face of said dielectric resonator (1) is an almost regular polygon, and the angle formed between two sides drawn from each vertex is an obtuse angle.

7. The invention of any preceding claim, wherein a guide or a groove (30) for attaching said dielectric resonator (1) is provided in the dielectric substrate (12, 29) or the semiconductor substrate (21), on which said coupled line is formed.

8. The invention of any preceding claim, further comprising a variable reactance element (5) and means for changing the reactance of the variable reactance element between an active element (2) of said oscillation circuit (24) and said coupled line (3).
